# EUROPEAN PATENT APPLICATION

(11) **EP 3 687 069 A1**
(43) Date of publication of application: **29.07.2020**
(21) Application number: 19183161.9
(22) Date of filing: 28.06.2019
(51) Int. Cl.: H03L 1/02, H03L 7/16, H03J 7/06, H04W 4/70

(54) **TEMPERATURE STABILIZED OSCILLATOR CIRCUIT FOR NB-IOT DEVICES**

(30) Priority: 24.01.2019 EP 19153566
(71) Applicant: SHENZHEN GOODIX TECHNOLOGY CO., LTD., Shenzhen, Guangdong 518045 (CN)
(72) Inventor: Andreas, Bury, 01099 Dresden (DE)
(74) Representative: Lippert Stachow Patentanwälte Rechtsanwälte Partnerschaft mbB

(57) **Abstract**

The invention relates to a temperature stabilized oscillator circuit of a radio transceiver for a NB-IoT device comprising a crystal oscillator (XO) for providing a clock for operating the NB-IoT device, a phase locked loop (PLL) synthesizer for multiplying the clock provided by the crystal oscillator to feed an up-mixer in the TX path and a down-mixer in the RX path, and a frequency offset estimation unit for estimating a frequency offset between the clock of the crystal oscillator and received signals of from a base station. The object to find a possibility to reduce the bill of material for NB-IoT devices using a cheap clock source which can reliably support a wide temperature range with a constant clock frequency will be solved therein that the crystal oscillator comprises a crystal for generating the clock, and a diode, which is placed with good thermal coupling closely to the crystal for monitoring a temperature of the crystal by measuring a voltage of the diode, whereas pairs of measured voltage and estimated frequency offset are provided to a temperature compensation learning algorithm for selecting a correct phase locked loop frequency ratio for controlling and setting a frequency of the phase locked loop synthesizer.

## Description

The invention relates to a temperature stabilized oscillator circuit of a radio transceiver for a Narrowband Internet-of-Things (NB-IoT) device comprising a receive path for converting received analog radio frequency (RF) signals into digital baseband (BB) signals, a transmit path (TX) for converting digital BB signals into transmitted analog RF signals, a crystal oscillator (XO) for providing a clock for operating the NB-IoT device, a phase locked loop (PLL) synthesizer for multiplying the clock provided by the crystal oscillator to feed an up-mixer in the TX path and a down-mixer in the RX path, and a frequency offset estimation unit for estimating a frequency offset between the clock of the crystal oscillator and received signals from a base station.

It is the foremost goal to lower costs in mobile phone transceiver and to harmonize multiple transmission schemes such as GSM (Global System for Mobile Communication), UMTS (Universal Mobile Telecommunication System), and LTE (Long Term Evolution).

It has become state of the art to utilize as a clock source a free running crystal oscillator, i.e., without any voltage control to pull the frequency. To support a wide temperature range, typically a so called TCXO (Temperature Compensated Crystal Oscillator) device would be utilized.

Furthermore, plain crystals packaged together with an NTC (a resistor with Negative Temperature Coefficient) as a temperature sensor are available on the market, but due to the highly nonlinear characteristic of the NTC, they would be useful only in a very limited temperature range.

Transceivers supporting the ETSI (European Telecommunication Standardization Institute) 3GPP (3rd Generation Partnership Project) NB-IoT (Narrowband Internet of Things) radio transmission protocol typically require to meet a very low price point to succeed on the Internet-of-Things market. A TCXO device is a significant contributor to the bill of material. It contains the actual crystal, an oscillator circuit, a temperature sensor, varactor diodes to tune the crystal frequency, and compensation circuitry which may be either fully analog or employ analog-to-digital and digital-to-analog conversion, converting the sensor signal into a control signal for the varactor diodes.

Furthermore, it may not compensate the aging of the crystal, i.e., reduction of the crystal frequency over its life time. This conflicts with the requirement of a ten years lifetime for common Internet-of-Things devices, such as wireless water consumption meters. The temperature range to be supported by IoT devices may be significant, e.g., -40 ... 70 degrees Celsius, which translates into an even larger range for the crystal, e.g., -40 ... 85 degrees Celsius. When the NB-IoT device operates, especially the transmitter power amplifier may produce a significant amount of heat, which eventually propagates to the crystal and changes its temperature, and thus, the clock frequency. However, the requirement to the accuracy of the carrier frequency during transmission in NB-IoT is fairly tight, meaning that there may be a need to re-adjust the carrier frequency during transmission.

It is therefore an objective of the invention to find a possibility to reduce the bill of material for Internet-of-Things devices using a cheap clock source which can reliably support a wide temperature range with a constant clock frequency.

The object of the invention will be solved therein that the crystal oscillator comprises a crystal for generating the clock, and a diode, which is placed with good thermal coupling closely to the crystal for monitoring a temperature of the crystal by measuring a voltage of the diode, whereas pairs of measured voltage and estimated frequency offset are provided to a temperature compensation learning algorithm for selecting a correct phase locked loop frequency ratio for controlling and setting a frequency of the phase locked loop synthesizer.

The bill of material can be reduced by equipping a plain crystal with a diode as a temperature sensor. Good thermal coupling means an appropriate thermal coupling between diode and crystal and thermal insulation of the crystal/diode combination with respect to the heat source and which ensure that the measured temperature reflects well the crystal temperature. All circuitry resides in the existing system-on-chip: the oscillator, a constant current source to drive the diode, and an analog-to-digital converter to measure the voltage on the diode, which is in a wide range roughly proportional to absolute temperature.

There is no means to control the frequency of the crystal oscillator itself, but rather only the derived carrier frequencies and sampling frequencies, via control of PLL (phase locked loop) frequency ratios, and re-sampling ratios.

After one-point factory calibration, frequency offset estimates on the signals received from base stations are fed together with associated temperature measurements into a learning algorithm, which allows to select the right PLL frequency ratio based on a temperature measurement, within the already experienced temperature range and beyond. Already experienced temperature range refers to the data set that was already recorded over the past device life time..

In a preferred embodiment of the inventive temperature stabilized oscillator circuit, signals received from the base station are used as a reference for the clock generated by the crystal oscillator for operating the NB-IoT device. The base station signal has fairly high temperature stability and is used therefore as a reference.

In another embodiment of the inventive temperature stabilized oscillator circuit, the diode is fed forward biased with a constant current, resulting in a larger linear operation region. The voltage of the diode is fed into an analog-to-digital converter.

In another further embodiment of the inventive temperature stabilized oscillator circuit, the diode is operated with a serially connected resistor and a constant voltage source, also resulting in a larger linear operation region.

In a preferred embodiment of the inventive temperature stabilized oscillator circuit, the pairs of measured voltage and estimated frequency offset are recorded for compensating the temperature dependency of the crystal frequency as well as the long-term change of crystal frequency due to aging. During operation, regular measurement of the crystal temperature allows to compensate for frequency change caused by self-generated heat-up. And the temperature learning algorithm supports to forget very old measurements, in order to cope with aging of the crystal.

In a further preferred embodiment of the inventive temperature stabilized oscillator circuit, the voltage of the diode is measured periodically. Periodic measurement of the diode voltage allows monitoring the crystal temperature and compensating for the change in carrier frequency, in order to satisfy requirements on carrier frequency accuracy given by the 3GPP standard of NB-IoT.

In an embodiment of the temperature stabilized oscillator circuit, the crystal and the diode are formed as far as possible away from a heat producer. To achieve sufficient accuracy a good temperature matching between diode and crystal is crucial. This is achieved by close mounting and good thermal coupling between diode and crystal, together with a placement of the "crystal/diode" pair as far as possible away from the largest heat producer, which is typically the power amplifier.

Hence, in another embodiment of the temperature stabilized oscillator circuit, a thermal isolation is formed between the crystal, the diode and a substrate, on which the crystal and the diode are mounted. This helps to improve temperature matching between diode and crystal during a temperature rise caused by self-heat-up. The crystal and the diode may be separate devices mounted closely on a common substrate, such that sufficiently good thermal coupling is achieved.

In a further embodiment of the temperature stabilized oscillator circuit the temperature of the crystal is monitored by a bipolar transistor, with basis and collector connected to serve as a more ideal diode, even when operated with a resistor instead of a current source.

In another further embodiment of the inventive temperature stabilized oscillator circuit separated phase locked loop synthesizers are formed feeding the up-mixer in the TX path and the down-mixer in the RX path, for frequency division duplexing operation.

The invention will be explained in more detail using exemplary embodiments.

The appended drawings show
- Fig. 1: the inventive temperature stabilized oscillator circuit;
- Fig. 2: the inventive temperature stabilized oscillator circuit on a common substrate.

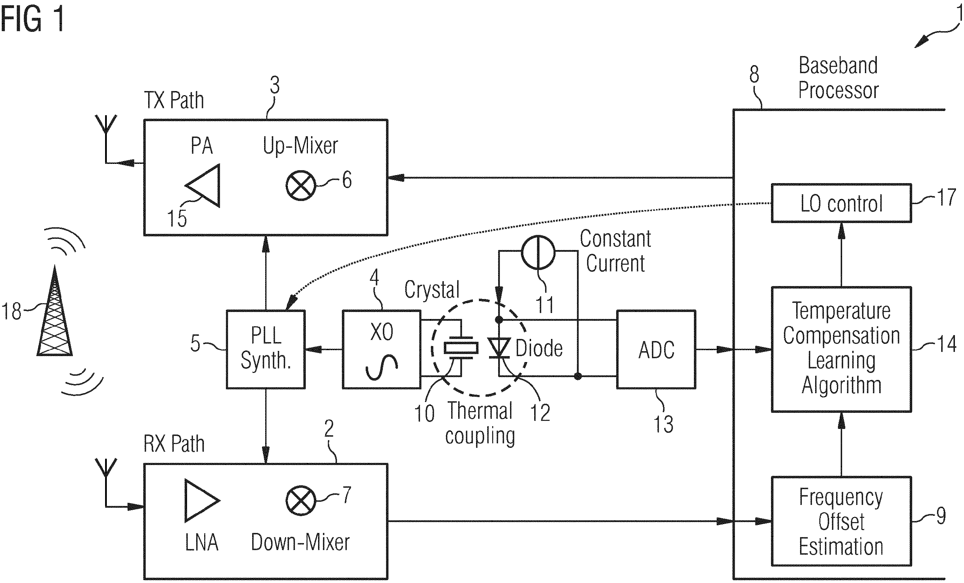

Figure 1 shows the inventive temperature stabilized oscillator circuit 1. A radio transceiver for NB-IoT comprises a receive path 2, converting received analog radio frequency (RF) signals into digital baseband (BB) signals, a transmit path 3, converting digital BB signals into transmitted analog RF signals, a crystal oscillator (XO) 4 providing a clock to operate the system, a phase locked loop (PLL) synthesizer 5 multiplying the clock provided by the crystal oscillator 4 to feed the up-mixer 6 in the TX path 3 and the down-mixer 7 in the RX path 2. The crystal oscillator 4 utilizes a crystal to control the oscillation. A diode 12 is placed with good thermal coupling closely to the crystal 10. The diode 12 is fed forward biased with a constant current 11, and the voltage across the diode's P-N transition is fed into an analog-to-digital converter (ADC) 13. Besides data reception and transmission, the baseband processor 8 which comprises the temperature learning algorithm unit 14, the frequency offset estimation unit 9 and the frequency control unit 17 of the PLL synthesizer 5, records readings of the voltage measurement across the diode 12 in pairs with related frequency offset estimates of the received signal with respect to its nominal value, which is known based on the scheme of possible carrier frequencies.

Pairs of measured voltage and estimated frequency offset are fed into a learning algorithm which targets at estimating current parameters of the crystals S-curve shape (frequency versus temperature curve), considering aging. For battery-operated devices, low power consumption is critical. Typically the modem would sleep for long periods of time and when it comes to data transmission shall minimize its on-duration. Based on the so far acquired set of such pairs it is possible to set the frequency correctly using the current diode voltage reading. New voltage / frequency offset pairs are recorded as part of the necessary signal reception. Furthermore, the power amplifier (PA) 15 in the transmit path 3 produces a significant amount of heat due to power losses. During a long transmission at high power, heat will propagate through the mounting substrate 16 to the crystal 10 and change its temperature and frequency. Periodic measurement of the diode voltage allows monitoring the crystal temperature and compensating for the change in carrier frequency, in order to satisfy requirements on carrier frequency accuracy given by the 3GPP standard of NB-IoT.

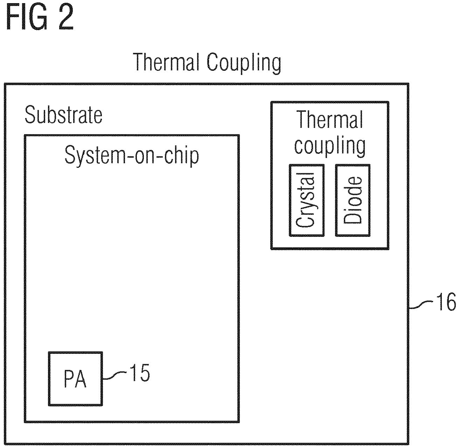

To achieve sufficient accuracy a good temperature matching between diode 10 and crystal 12 is crucial. This is achieved by close mounting and good thermal coupling between diode 10 and crystal 12, together with a placement of the "crystal/diode" pair as far as possible away from the largest heat producer, which is typically the power amplifier 15. This is shown in figure 2. Furthermore, thermal isolation between the diode/crystal pair and the substrate 16 helps to improve temperature matching between diode 12 and crystal 10 during a temperature rise caused by self-heat-up.

Alternative to the forward biased diode, a bipolar transistor may be used to measure the crystal temperature. The crystal and the diode may be separate devices mounted closely on a common substrate, such that sufficiently good thermal coupling is achieved.

### Temperature stabilized oscillator circuit for NB-IoT devices

### List of Reference Signs

- 1: Temperature stabilized oscillator circuit
- 2: receive path
- 3: transmit path
- 4: crystal oscillator
- 5: phase locked loop synthesizer
- 6: up-mixer
- 7: down-mixer
- 8: baseband processor
- 9: frequency offset estimation unit
- 10: crystal
- 11: constant current source
- 12: diode
- 13: analog-to-digital converter
- 14: temperature compensation learning algorithm unit
- 15: power amplifier
- 16: substrate
- 17: crystal oscillator control unit
- 18: base station

## Claims

1. A temperature stabilized oscillator circuit of a radio transceiver for a Narrowband Internet-of-Things device (1) comprising a receive path (2) for converting received analog radio frequency signals into digital baseband signals, a transmit path (3) for converting digital BB signals into transmitted analog RF signals, a crystal oscillator (4) for providing a clock for operating the NB-IoT device, a phase locked loop synthesizer (5) for multiplying the clock provided by the crystal oscillator (4) to feed an up-mixer (6) in the TX path (3) and a down-mixer (7) in the RX path (2), and a frequency offset estimation unit (9) for estimating a frequency offset between the clock of the crystal oscillator (4) and received signals from a base station (18), **wherein** the crystal oscillator (4) comprises a crystal (10) for generating the clock, and a diode (12), which is placed with good thermal coupling closely to the crystal (10) for monitoring a temperature of the crystal (10) by measuring a voltage of the diode (12), whereas pairs of measured voltage and estimated frequency offset are provided to a temperature compensation learning algorithm for selecting a correct phase locked loop frequency ratio for controlling and setting a frequency of the phase locked loop synthesizer (5).

2. The temperature stabilized oscillator circuit (1) according to claim 1, wherein signals received from the base station (18) are used as a reference for the clock generated by the crystal oscillator (4) for operating the NB-IoT device.

3. The temperature stabilized oscillator circuit (1) according to claim 1, wherein the diode (12) is fed forward biased with a constant current. (11).

4. The temperature stabilized oscillator circuit (1) according to claim 1, wherein the diode (12) is operated with a serially connected resistor and a constant voltage source.

5. The temperature stabilized oscillator circuit (1) according to one of the former claims, wherein the voltage of the diode (12) is fed into an analog-to-digital converter (13).

6. The temperature stabilized oscillator circuit (1) according to one of the former claims, wherein the pairs of measured voltage and estimated frequency offset are recorded for compensating the temperature dependency of the crystal frequency as well as the long-term change of crystal frequency due to aging.

7. The temperature stabilized oscillator circuit (1) according to one of the former claims, wherein the voltage of the diode (12) is measured periodically.

8. The temperature stabilized oscillator circuit (1) according to one of the former claims, wherein the crystal (10) and the diode (12) are formed as far as possible away from a heat producer.

9. The temperature stabilized oscillator circuit (1) according to one of the former claims, wherein a thermal isolation is formed between the crystal (10), the diode (12) and a substrate (16), on which the crystal (10) and the diode (12) are mounted.

10. The temperature stabilized oscillator circuit (1) according to claim 1, wherein the temperature of the crystal (10) is monitored by a bipolar transistor.

11. The temperature stabilized oscillator circuit according to claim 1, wherein separated phase locked loop synthesizers (5) are formed feeding the up-mixer (6) in the TX path (3) and the down-mixer (7) in the RX path (2) .
